## Europäisches Patentamt

## European Patent Office

## Office européen des brevets

(11) Veröffentlichungsnummer: **0 223 956**
**B1**

(12) # EUROPÄISCHE PATENTSCHRIFT

(45) Veröffentlichungstag der Patentschrifft:
21.03.90

(21) Anmeldenummer: **86112997.1**

(22) Anmeldetag: **20.09.86**

(51) Int. Cl. ⁵: **G 01 R 19/145**

(54) Schaltungsanordnung zur Anzeige der Strom- und/oder Leistungsaufnahme duch eine elektrische Last.

(30) Priorität: **23.09.85 DE 3533862**

(43) Veröffentlichungstag der Anmeldung:
**03.06.87 Patentblatt 87/23**

(45) Bekanntmachung des Hinweises auf die Patenterteilung:
**21.03.90 Patentblatt 90/12**

(84) Bennante Vertragsstaaten:
**BE DE FR GB IT SE**

(56) Entgegenhaltungen:
**CH-A-572 219**
**DE-B-2 848 791**

(73) Patentinhaber: **Richard Hirschmann Radiotechnisches Werk**
**Richard-Hirschmann-Strasse 19 Postfach 110**
**D-7300 Esslingen a.N. (DE)**

(72) Erfinder: **Mayer, Hans-Dietrich, Dipl.-Ing. (FH)**
**Schulstrasse 19**
**D-7066 Baltmannsweiler (DE)**
Erfinder: **Hirrlinger, Klaus, Dipl.-Ing.**
**Plochinger Strasse 69**
**D-7300 Esslingen (DE)**

(74) Vertreter: **Stadler, Heinz, Dipl.-Ing.**
**Richard-Hirschmann-Strasse 19 Postfach 110**
**D-7300 Esslingen a.N. (DE)**

2

## Beschreibung

Die Erfindung betrifft eine Schaltungsanordnung zum kontinuierlichen Anzeigen der Stromaufnahme oder, bei im wesentlichen konstanter Versorgungsspannung, der Leistungsaufnahme einer elektrischen Last.

Meßinstrumente zum Messen der Stromstärke in Ampere oder der Leistung in Watt sind in vielfältigen Ausführungsformen bekannt, mit denen die Strom- oder Leistungsaufnahme von elektrischen Geräten auch kontinuierlich angezeigt werden kann. Derartige Instrumente sind jedoch recht aufwendig, besonders für Anwendungsfälle, bei denen eine einfache Anzeigeeinrichtung ausreicht, mit der festgestellt werden kann, ob wenig oder viel Strom fließt. Kostengünstiger sind Dreheisen-Instrumente, die insbesondere in der KFZ-Zubehörbranche eingesetzt werden und auch für die Anzeige der Strom- oder Leistungsaufnahme von derartigen Geräten dienen könnten. Da derartige Dreheisen-Instrumente bewegliche mechanische Teile aufweisen, sind sie jedoch nicht so preiswert und langlebig, daß sie geeignet erscheinen. Darüber hinaus weisen derartige Instrumente kleine Zeigerwinkel-Ausschläge mit 90° bis 100° auf, wobei der Zeigerausschlag nicht linear zu der zu messenden Leistung bzw. zu dem zu messenden Strom erfolgt. Dadurch werden bestimmte Anzeige- bzw. Meßbereiche sehr gedrängt, wodurch die Anzeigegenauigkeit zu wünschen übrig läßt.

Insbesondere im Zusammenhang mit elektrischen Haushaltsgeräten, wie beispielsweise Waschmaschinen, Kühlschränken, Klimageräten, automatischen Kochplatten, Heizkissen usw., besteht häufig das Bedürfnis, die augenblickliche Stromaufnahme bzw. den momentanen Leistungsverbrauch zu kennen, wobei es dabei weniger um absolute Werte als vielmehr um einfache Hinweise geht, ob viel oder weniger Strom fließt. Strom- bzw. Leistungs-Meßgeräte, auch preiswerte Dreheisen-Instrumente, sind für diese Anwendungsfälle zu aufwendig und zu teuer und auch nicht so kompakt herzustellen, daß sie beispielsweise in einem Steckergehäuse untergebracht werden können.

Aus der DE-B-2 848 791 ist eine Schaltungsanordung zur Anzeige der Strom- oder Leistungsaufnahme einer elektrischen Last bekannt. Bei dieser Schaltungsanordnung wird zur Anzeige eine entsprechend angesteuerte Leuchtdiode verwendet.

Im Zusammenmhang mit der vorliegenden Erfindung wurde die Verwendung einer Leuchtdiode ins Auge gefaßt, deren Helligkeit sich in Abhängigkeit der Stromaufnahme eines Geräts ändert. Dabei hatte sich jedoch herausgestellt, daß eine ausreichend große Abstufung der Leuchtdioden-Helligkeit zur Feststellung, ob viel oder weniger Strom fließt, nicht möglich ist, weil die Helligkeitsempfindlichkeit des menschlichen Auges nicht linear, sondern logarithmisch ist und Leuchtdioden eine rasche Leuchtsättigung aufweisen. Die sich daran anschließende Überlegung, den Leuchtbereich der Leuchtdioden durch Pulsbreitensteuerung auszuweiten, ergab nur geringe Anzeigenverbesserungen. Auch die Ausweitung des Anzeigenbereichs durch mehrere mit Analog/Digitalwandlern kaskadierte Leuchtdioden-Indikatoren ist im vorliegenden Falle nicht anwendbar, da ein derartiger Leistungsindikator genauso wie bei der Verwendung von numerischen Leuchtdioden oder LCD-Anzeigen zu aufwendig und kostenintensiv würde.

Der Erfindung liegt daher die Aufgabe zugrunde, eine Schaltungsanordnung zum kontinuierlichen Anzeigen der Strom- oder Leistungsaufnahme insbesondere für elektrische Haushaltsgeräte zu schaffen, mit der eine einfache und kostengünstige qualitative Anzeige des Stroms oder der Leistung möglich ist, die von den wechselnde Leistungen aufnehmenden Haushaltsgeräten, wie Waschmaschinen, Kühlschränken, Klimageräten, Kochplatten, Heizkissen usw., verbraucht werden. Darüber hinaus soll die Schaltungsanordnung und die mit ihr verbundene Anzeigeeinrichtung eine kompakte Einheit bilden, die auch in kleinsten Gehäusen, wie Steckergehäusen usw., untergebracht werden kann.

Gelöst wird die gestellte Aufgabe mit einer Schaltungsanordnung zum kontinuierlichen Anzeigen der Stromaufnahme oder, bei im wesentlichen konstanter Versorgungspannung der Leistungsaufnahme einer elektrischen Last, wobei eine für die Anzeige vorgesehene Leuchtdiode mit Spannungsimpulsen angesteuert wird, deren Folgefrequenz der Stärke des aufgenommenen Stromes entspricht und diese Frequenz, innerhalb des anzuzeigenden Bereiches, unterhalb der für das menschliche Auge noch aufzulösenden Blinkfrequenz liegt.

Trotz der Verwendung einer als Bauelement sehr kostengünstigen Leuchtdiode als Anzeigeeinrichtung kann mit der erfindungsgemäßen Schaltungsanordnung dennoch eine ausreichend auf lösende qualitative Anzeige erreicht werden, ob ein elektrisches Gerät im Moment der Betrachtung viel oder wenig Strom zieht. Der Vergleich unterschiedlicher Blinkfrequenzen gelingt dem menschlichen Auge wesentlich besser als der Vergleich unterschiedlicher Helligkeiten. Die mit der erfindungsgemäßen Schaltungsanordnung ausgerüstete Anzeigeanordnung ist daher sehr kostengünstig und dennoch für den vorgesehenen Einsatz gut geeignet. Beispielsweise kann die Schaltungsanordnung derart gewählt sein, daß einer Blinkfrequenz von 1 Hz die Leistung von 50 Watt entspricht, so daß die Blinkfrequenz bei Zunahme der Leistungsaufnahme bis zu 1 kW linear auf ca. 20 Hz ansteigt. Ab ca. 20 Hz löst das menschliche Auge die einzelnen Blitze der Leuchtdiode nicht mehr auf, sondern sieht die Leuchtdiode kontinuierlich leuchten. Selbstverständlich ist es auch möglich, den Blinkfrequenzbereich von 20 Hz, in dem das menschliche Auge die einzelnen Lichtblitze noch unterscheiden kann, auf einen größeren Leistungsbereich, etwa auf einen Leistungsbereich von 3 kW auszudehnen.

Wenn es sich bei der elektrischen Last etwa um Haushaltsgeräte, wie Waschmaschinen, Kühlschränke, Klimageräte, Kochplatten usw., handelt, die am kommunalen Stromnetz angeschlossen sind, bei dem die Versorgungsspannung im wesentlichen konstant ist, so kann mit der erfindungsgemäßen Schaltungsanordnung die ungefähre Leistungsaufnahme der elektrischen Last kontinuierlich angezeigt werden.

Die gestellte Aufgabe wird erfindungsgemäß weiterhin gelöst mit einer Schaltungsanordnung zum kontinuierlichen Anzeigen der Stromaufnahme oder, bei im wesentlichen konstanter Spannung der Leistungsaufnahme einer elektrischen Last, wobei eine für die Anzeige vorgesehene Leuchtdiode mit Spannungsimpulsen angesteuert wird, deren Folgefrequenz der Stärke des aufgenommenen Stromes entspricht und diese Frequenz, innerhalb des anzuzeigenden Bereiches, in einem ersten Anzeigebereich unterhalb der für das menschliche Auge noch auf zulösenden Blinkfrequenz und in einem zweiten Anzeigebereich oberhalb der für das menschliche Auge noch aufzulösenden Blinkfrequenz liegt.

Häufig möchte man im unteren Bereich der Leistungsaufnahme eine genauere Anzeige, und im oberen Leistungsbereich reicht eine ungenauere Anzeige aus. Dieser Tatsache trägt die letztgenannte Ausführungsform der Erfindung Rechnung. Beispielsweise ist die Schaltungsanordnung derart ausgelegt, daß der erste Anzeigebereich einen Leistungsbereich von 0 bis 1000 W mit einer Blinkfrequenzänderung von 1 bis 20 Hz überstreicht, und daß sich der zweite Anzeigebereich daran anschließt und von 1 bis 3 kW reicht, wobei die Leuchtdiode dann im zweiten Bereich in ihrer Helligkeit zunimmt.

Gemäß einer vorteilhaften Ausgestaltung der Erfindung wird bei der erfindungsgemäßen Schaltungsanordnung an einem im Laststromkreis liegenden Widerstand eine Spannung abgegriffen, diese mittels eines Gleichrichters gleichgerichtet und danach einem Spannungs-/Impulsfolge-Umsetzer zugeleitet, dessen Ausgangssignal die Leuchtdiode ansteuert.

Vorteilhaft ist es weiterhin, wenn der für den Spannungsabgriff vorgesehene Widerstand einen kleinen, den Laststromkreis im wesentlichen nicht belastenden Widerstandswert aufweist und wenn ein der Verstärkung der abgegriffenen Spannung dienender Verstärker vorgesehen ist. Der Laststromkreis soll durch die Anschaltung des Leistungsindikators möglichst unbeeinflußt bleiben, d. h. der Spannungsabfall durch den für den Spannungsabgriff vorgesehenen Widerstand soll möglichst gering sein. Dieser Forderung trägt die genannte Ausführungsform Rechnung. Da die Schaltungsanordnung üblicherweise in einem kleinen Gehäuse untergebracht ist, sollte die Verlustleistung durch den Widerstand ebenfalls gering bleiben, damit sich die Schaltungsanordnung nicht aufheizt. Auch dieser Forderung wird durch die beschriebene Ausführungsform genügt.

Vorteilhaft ist es auch, die gesamte Schaltung einschließlich der Leuchtdiode in einem Steckergehäuse in kompakter Anordnung unterzubringen. Das Steckergehäuse kann andererseits eine Steckdose aufweisen, so daß die gesamte Vorrichtung zum qualitativen Anzeigen der Strom- oder Leistungsaufnahme gemäß der vorliegenden Erfindung als kostengünstiges Massenprodukt hergestellt und in der Weise wie in Steckdosen einsteckbare Schaltuhren benutzt werden kann.

Die Erfindung wird nachstehend anhand der Zeichnungen beispielsweise näher erläutert. Es zeigen:

Fig 1    die schematische Darstellung einer erfindungsgemäßen Schaltungsanordnung, und

Fig. 2    eine ins einzelne gehende Ausführungsform der Schaltungsanordnung.

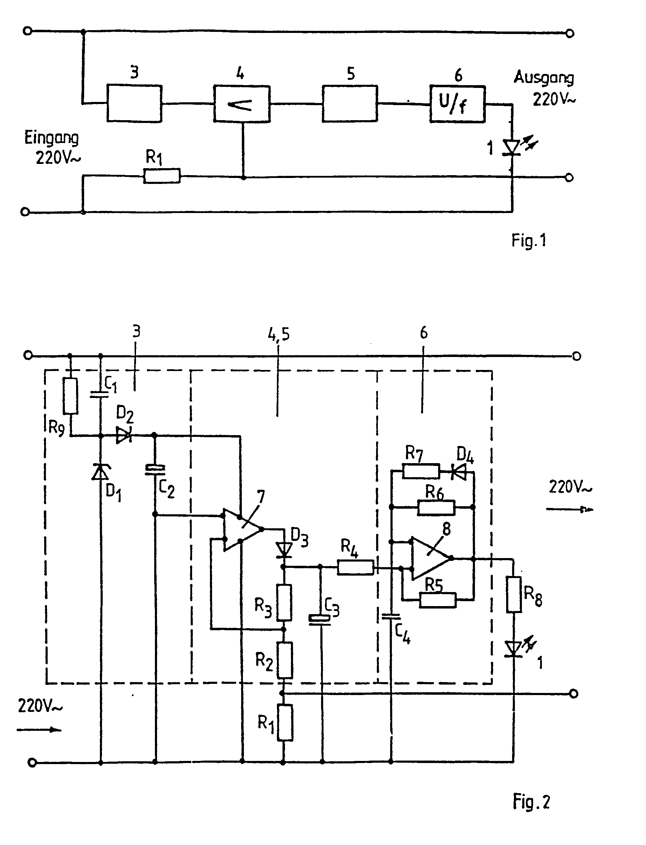

Bei dem in Fig. 1 schematisch darstellten Ausführungsbeispiel liegt am Eingang die Netzwechselspannung von 220 Volt an. Während die eine Eingangsklemme direkt mit der Ausgangsklemme verbunden ist, liegt zwischen der anderen Eingangsklemme und der anderen Ausgangsklemme ein Widerstand $R_1$, der vorzugsweise so klein, beispielsweise zu 0,02 Ohm gewählt ist, daß der Spannungsabfall für den Laststromkreis praktisch vernachlässigbar ist.

Am Widerstand $R_1$ wird der an ihm auftretende Spannungsabfall abgegriffen und einem Verstärker 4 zugeleitet, der von einem Netzteil 3 versorgt wird. Das Ausgangssignal des Verstärkers wird in einem Gleichrichter 5 gleichgerichtet. Die am Ausgang des Gleichrichters auftretende Gleichspannung wird in einer anschließenden Schaltungsstufe 6 in eine Impulsfolge umgewandelt, deren Frequenz proportional der Eingangsspannung ist. Mit der Impulsfolge wird eine Leuchtdiode 1 angesteuert, deren Kathode am anderen Eingang der Netzspannung liegt. Die am Widerstand $R_1$ abgegriffene Spannung ist dem von der Last, beispielsweise dem von einem elektrischen Haushaltsgerät aufgenommenen Strom proportional. Diese Spannung wird nach Verstärkung und Gleichrichtung im Spannungs-/Impulsfolge-Umsetzer 6 in eine Impulsfolge umgesetzt, deren Frequenz der am Widerstand $R_1$ abgegriffenen Spannung und damit dem vom elektrischen Gerät aufgenommenen Strom bzw. der vom elektrischen Gerät verbrauchten Leistung proportional ist. Die Leuchtdiode blinkt also in einer der Stromaufnahme bzw. dem Leistungsverbrauch des elektrischen Geräts entsprechenden Frequenz.

Fig. 2 zeigt eine ins einzelne gehende Ausführungsform des in Fig. dargestellten Beispiels einer erfindungsgemäßen Schaltung. Schaltungsteile und Schaltungselemente, die denen von Fig. 1 entsprechen, sind mit denselben Bezugszeichen versehen.

Das Netzteil 3, das einem Verstärker 7 eine Gleichspannung als Versorgungsspannung bereitstellt, weist einen Kondensator $C_1$ (0,22 μF) auf, der als kapazitiver Vorwiderstand für die mit

den Dioden $D_1$ (Z 12) und $D_2$ (4148) als spannungsstabilisierender Gleichrichter arbeitende Schaltung wirkt. Ein dem Kondensator $C_1$ parallelgeschalteter Widerstand $R_9$ (1 M Ohm) verhindert Stromschläge, die beim Herausziehen des Gerätes aus der Steckdose und dem versehentlichen Berühren der Steckkontakte durch Restladung des Kondensators $C_1$ auftreten könnten. Die Kathode der Diode $D_2$ steht mit einem Glättungskondensator $C_2$ (1000 µF) in Verbindung, die Kombination der Diode $D_2$ und des Kondensators $C_2$ dient der Gleichrichtung, so daß das Netzteil 3 eine Betriebsgleichspannung von 12 V bereitstellt. Dieser Schaltungsteil ist also in herkömmlicher Bauweise ausgebildet und nicht Gegenstand der Erfindung.

Im Lastromkreis, d. h. zwischen dem anderen Anschluß des Netzeingangs und dem anderen Anschluß des Schaltungsausgangs liegt ein Widerstand $R_1$, der vorzugsweise so gewählt ist, daß an ihm bei einer üblichen Stromaufnahme von Haushaltsgeräten ein Spannungsabfall im Millivoltbereich auftritt. Beim hier vorliegenden Ausführungsbeispiel hat der Widerstand $R_1$ den Wert 0,02 Ohm. Diese Spannung wird in einem Schaltungsteil 4,5, in dem der Verstärker 4 und der Gleichrichter 5 von Fig. 1 zusammengefaßt sind, sowohl verstärkt als auch gleichgerichtet. Am oberen Anschluß des Widerstands $R_1$ bzw. an der anderen Klemme des Schaltungsausgangs liegen in Reihe geschaltete Widerstände $R_2$ (6,8 kOhm) und $R_3$ (180 kOhm), deren Verbindungspunkt mit dem einen Eingang eines Verstärkers 7 verbunden ist, während der andere Eingang mit der anderen Klemme des Netzeingangs in Verbindung steht. Der Verstärker 7 wird, wie bereits erwähnt, vom Netzteil 3 mit der Betriebsspannung versorgt. Der Ausgang des Verstärkers 7 steht mit der Anode einer Diode $D_3$ (4148) in Verbindung, deren Kathode mit dem anderen Anschluß des Widerstands $R_3$ sowie mit dem einen Anschluß eines Kondensators $C_3$ (2,2 µF) verbunden ist, dessen anderer Anschluß an der anderen Klemme des Netzeingangs liegt.

Die als Gleichrichter wirkende Diode $D_3$, die an sich erst ab 0,6 V gleichrichten könnte, tut dies auf Grund der vorausgehenden Verstärkung der Spannung im Verstärker 7 sozusagen bereits im Millivolt-Bereich, so daß die am Widerstand $R_1$ abgegriffene Spannung gleichgerichtet und am Kondensator $C_3$ eine proportionale Gleichspannung bereitgestellt wird. Die Widerstände $R_2$ und $R_3$ dienen der Einstellung des Verstärkungsfaktors des Verstärkers 7. Durch Änderung dieser Widerstandswerte und damit des Verstärkungsfaktors des Verstärkers 7 läßt sich daher die Blinkfrequenzänderung für eine bestimmte, am Widerstand $R_1$ auftretende Spannungsänderung und damit für eine bestimmte Leistungsaufnahme des elektrischen Geräts einstellen. Bezüglich der Empfindlichkeit beim vorliegenden Ausführungsbeispiel entsprechen 10 W etwa 1 Sekunde. Selbstverständlich sind auch andere Empfindlichkeitseinstellungen möglich.

Über einen Widerstand $R_4$ (39 kOhm) liegt die der am Widerstand $R_1$ abgegriffenen Spannung proportionale Gleichspannung an der Schaltungsstufe 6 für die Umsetzung der Gleichspannung in eine Impulsfolge an. Das Eingangssignal für diese Schaltungsstufe wird einem Eingang eines als Impulsgenerator dienenden Differenzverstärkers 8 zugeleitet, dessen anderer Eingang über einen Kondensator $C_4$ (0,1 µF) am anderen Anschluß des Netzspannungseingangs anliegt. Der Ausgang des Differenzverstärkers 8 steht mit dem einen Eingang über einen Widerstand $R_5$ (120 kOhm) und mit dem anderen Eingang über eine Reihenschaltung in Verbindung, die aus einer Diode $D_4$ (4148) und einem Widerstand $R_7$ (120 kOhm) besteht. Dieser Reihenschaltung liegt ein Widerstand $R_6$ (11 MOhm) parallel. Das Ausgangssignal des Spannungs-/Impulsfolge-Umsetzers 6 bzw. des Differenzverstärkers 8 gelangt über einen Widerstand $R_8$ (1,5 kOhm) an die Anode einer Leuchtdiode 1. Die Frequenz des Ausgangssignals ist proportional der am Eingang des Spannungs-/Impulsfolge-Umsetzers anliegenden Spannung und damit proportional der am Widerstand $R_1$ abgegriffenen Spannung. Mit anderen Worten, die Blinkfrequenz der Leuchtdiode 1 ist proportional dem vom elektrischen Gerät aufgenommenen Strom bzw. der vom elektrischen Gerät verbrauchten Leistung im Moment der Betrachtung. Die Leuchtdiode blinkt also bei zunehmender, vom elektrischen Gerät verbrauchter Leistung mit zunehmender Frequenz.

**Patentansprüche**

1. Schaltungsanordnung zum kontinuierlichen Anzeigen der Stromaufnahme oder, bei im wesentlichen konstanter Versorgungspannung der Leistungsaufnahme einer elektrischen Last, wobei eine für die Anzeige vorgesehene Leuchtdiode (1) mit Spannungsimpulsen angesteuert wird, deren Folgefrequenz der Stärke des aufgenommenen Stromes entspricht und diese Frequenz, innerhalb des anzuzeigenden Bereiches, unterhalb der für das menschliche Auge noch aufzulösenden Blinkfrequenz liegt.

2. Schaltungsanordnung zum kontinuierlichen Anzeigen der Stromaufnahme oder, bei im wesentlichen konstanter Versorgungspannung der Leistungsaufnahme einer elektrischen Last, wobei eine für die Anzeige vorgesehene Leuchtdiode (1) mit Spannungsimpulsen angesteuert wird, deren Folgefrequenz der Stärke des aufgenommenen Stromes entspricht und diese Frequenz, innerhalb des anzuzeigenden Bereiches, in einem ersten Anzeigebereich unterhalb der für das menschliche Auge noch aufzulösenden Blinkfrequenz und in einem zweiten Anzeigebereich oberhalb der für das menschliche Auge noch aufzulösenden Blinkfrequenz liegt.

3. Schaltungsanordnung nach Anspruch 1 oder 2, bei der an einem im Laststromkreis liegenden Widerstand ($R_1$) eine Spannung abgegriffen,

diese mittels eines Gleichrichters (5) gleichgerichtet und einem Spannungs-/Impulsfolge-Umsetzer (6) zugeleitet wird, mit dessen Ausgangssignal die Leuchtdiode (1) angesteuert wird.

4. Schaltungsanordnung nach Anspruch 3, bei der der für den Spannungsabgriff vorgesehene Widerstand (R₁) einen kleinen, den Laststromkreis im wesentlichen nicht belastenden Widerstandswert aufweist, und bei der ein für die Verstärkung der abgegriffenen Spannung vorgesehener Verstärker (4) vorgesehen ist.

5. Schaltungsanordnung nach einem der Ansprüche 1 bis 4, wobei diese in einem Steckergehäuse untergebracht ist.

**Revendications**

1. Circuit pour indiquer en continu l'absorption de courant et/ou de puissance d'une charge électrique, dans lequel une diode électroluminescente (1) prévue pour l'indication est excitée par des impulsions de tension dont la fréquence de répétition correspond à l'intensité du courant absorbé et dans lequel cette fréquence se situe, à l'intérieur de la gamme indiquer, en-dessous de la fréquence de clignotement pouvant être perçue par l'oeil humain.

2. Circuit pour indiquer en continu l'absorption de courant et/ou de puissance d'une charge électrique, dans lequel une diode électroluminescente (1) prévue pour l'indication est excitée par des impulsions de tension dont la fréquence de répétition correspond à l'intensité du courant absorbé et dans lequel cette fréquence, à l'intérieur de la gamme à indiquer, se situe dans une première gamme d'indication sous la fréquence de clignotement pouvant être perçue par l'oeil humain, et dans une seconde gamme d'indication au-dessus de la fréquence de clignotement pouvant être perçue par l'oeil humain.

3. Circuit selon les revendications 1 ou 2, dans lequel une tension est prélevée sur une résistance (R₁) située dans le circuit du courant de charge, dans lequel cette tension est redressée à l'aide d'un redresseur (5) et transmise à un convertisseur tension/série d'impulsions (6), avec la signal de sortie duquel la diode électroluminescente (1) est excitée.

4. Circuit selon la revendication 3, dans lequel la résistance (R₁) prévue pour le prélèvement de tension présente une valeur de résistance faible n'entraînant pratiquement pas de sollicitation du circuit du courant de charge, et dans lequel il est prévu un amplificateur (4), destiné à amplifier la tension prélevée.

5. Circuit selon l'une des revendications 1 à 4, logé dans un boîtier de connecteur.

**Claims**

1. Circuit arrangement for continuously indicating the current consumption or, at substantially constant supply voltage, power consumption of an electrical load, wherein a light emitting diode (1) provided for the indication is triggered with voltage pulses, the repetition rate of which corresponds to the intensity of the consumed current and this rate, within the range to be indicated, is below the blink rate which can still be resolved by the human eye.

2. Circuit arrangement for continuously indicating the current consumption or, at substantially constant supply voltage, power consumption of an electrical load, wherein a light emitting diode (1) provided for the indication is triggered with voltage pulses, the repetition rate of which corresponds to the intensity of the consumed current, and this rate, within the range to be indicated, in a first indication range, is below the blink rate which can still be resolved by the human eye, and in a second indication range, is above the blink rate which can still be resolved by the human eye.

3. Circuit arrangement in accordance with claim 1 or 2, in which a voltage is picked up at a resistor (R₁) located in the load circuit, rectified by means of a rectifier (5) and supplied to a voltage/pulse train converter (6), with the output signal of which the light emitting diode (1) is triggered.

4. Circuit arrangement in accordance with claim 3, in which the resistor (R₁) provided for the voltage pickup has a low resistance that does not substantially load the load circuit, and in which an amplifier (4) is provided for amplifying the voltage picked up.

5. Circuit arrangement in accordance with one of claims 14, wherein it is accommodated in a contact plug housing.

Fig. 1

Fig. 2